# EUROPEAN PATENT APPLICATION

(11) **EP 3 330 808 A1**
(43) Date of publication of application: **06.06.2018**
(21) Application number: 17203044.7
(22) Date of filing: 22.11.2017
(51) Int. Cl.: G04B 37/22, C23C 14/16, C23C 30/00

(54) **TIMEPIECE PART AND TIMEPIECE**

(30) Priority: 24.11.2016 JP 2016228404
(71) Applicant: Seiko Epson Corporation, Tokyo 160-8801 (JP)
(72) Inventor: SOGO, Tomohiko, Nagano, 392-8502 (JP); KAWAKAMI, Atsushi, Nagano, 392-8502 (JP); TSUKAMOTO, Yuzuru, Nagano, 392-8502 (JP); TAKAHASHI, Hirokazu, Nagano, 392-8502 (JP)
(74) Representative: Hoffmann Eitle

(57) **Abstract**

Provided are a timepiece part having an outstanding appearance, outstanding corrosion resistance, and outstanding scuff resistance and wear resistance; and a timepiece having the timepiece part. The timepiece part has a substrate; and a first coating made from a material containing Co and including greater than or equal to 26 wt% and less than or equal to 30 wt% Cr, and greater than or equal to 5 wt% and less than or equal to 7 wt% Mo. The substrate is preferably made from a material including at least one of stainless steel and Ti. A second coating made of a material including at least one of TiC and TiCN is preferably disposed between the substrate and first coating.

## Description

### BACKGROUND

### 1. Technical Field

The present invention relates to a timepiece part and a timepiece.

### 2. Related Art

A timepiece requires functionality as a utilitarian product as well as outstanding aesthetic appeal (attractive appearance) as a decorative article.

As a result, precious metal materials with an outstanding feel are typically used for the case, wristband, and other timepiece parts. See, for example, Japan Patent 2990917.

However, precious metals are generally expensive, and have such problems as low hardness making them easily scratched and marred (poor scuff resistance).

### SUMMARY

The present invention provides a timepiece part having an outstanding aesthetic appeal, outstanding corrosion resistance, and outstanding scuff resistance and abrasion resistance, and provides a timepiece having said timepiece part.

The foregoing objective is achieved by the invention as described below.

A timepiece part according to the invention includes a substrate; and a first coating made from a material containing Co, preferably primarily Co, i.e., Co as/being the main component/constituent, and including greater than or equal to 26 wt% and less than or equal to 30 wt% Cr (i.e./meaning 26 wt% <= 30 wt% Cr), and greater than or equal to 5 wt% and less than or equal to 7 wt% Mo (i.e./meaning 5 wt% <= 7 wt% Mo). The above first coating material preferably consists of the indicated amounts/ranges of Cr and Mo with the remainder/rest being Co as the main component/constituent.

This enables providing timepiece parts with an outstanding aesthetic appeal (providing particularly high luster and a luxurious appearance), outstanding corrosion resistance, and outstanding scuff resistance and abrasion resistance.

In a timepiece part according to the invention, the substrate is preferably made from a material including, preferably consisting of, at least one of stainless steel and Ti.

This configuration can give the timepiece part particularly outstanding durability. Even when the first coating is relatively thin, desirable affects can be imparted to the overall appearance of the timepiece part, and an outstanding appearance can more reliably be imparted to the timepiece part.

Further preferably, a timepiece part according to the invention preferably has at least one underlayer made of a material containing, preferably consisting of, Ti between the substrate and first coating.

This configuration can give the timepiece part particularly outstanding durability. Subtle color adjustments can also be imparted to the entire timepiece part, and an outstanding appearance can more reliably be imparted to the timepiece part.

Further preferably, a timepiece part according to the invention preferably has a second coating made of a material including, preferably consisting of, at least one of TiC and TiCN between the substrate and first coating.

This configuration can further increase the hardness of the timepiece part, better enhance the dent resistance (difficulty forming indentations) of the timepiece part, and further enhance the durability of the timepiece part. The color (particularly the luster) can also be desirably adjusted.

Further preferably, a timepiece part according to the invention preferably has a second coating made of a material including, preferably consisting of, at least one of TiC and TiCN between the substrate and first coating; the underlayer being disposed on both sides of the second coating.

This configuration can give the timepiece part particularly outstanding durability. Subtle color adjustments can also be imparted to the entire timepiece part, and an outstanding appearance can more reliably be imparted to the timepiece part.

Further preferably, in a timepiece part according to the invention, the second coating preferably has a region in which the composition changes on a gradient through the thickness.

This configuration improves the dent resistance, scuff resistance, and abrasion resistance, for example, of the timepiece part, and achieves even more outstanding durability in the timepiece part while obtaining the effects of disposing the second coating, such as adjusting the color (particularly the luster).

Further preferably, in a timepiece part according to the invention, the second coating preferably has a region in which the total content of C and N decreases toward a surface of the second coating.

This configuration improves the dent resistance, scuff resistance, and abrasion resistance, for example, of the timepiece part, and achieves even more outstanding durability in the timepiece part while obtaining the effects of disposing the second coating, such as adjusting the color (particularly the luster).

Further preferably, in a timepiece part according to the invention, the second coating preferably has said region on both sides of the second coating.

This configuration can give the timepiece part particularly outstanding durability.

Further preferably, in a timepiece part according to the invention, the thickness of the second coating is preferably greater than or equal to 0.05 µm and less than or equal to 4.0 µm (i.e. 0.05 µm <= 4.0 µm).

This configuration can further increase the hardness of the timepiece part, better enhance the dent resistance (difficulty forming indentations) of the timepiece part, and further enhance the durability of the timepiece part. The color can also be desirably subtly adjusted.

Further preferably, in a timepiece part according to the invention, the thickness of the first coating is preferably greater than or equal to 0.02 µm and less than or equal to 2.0 µm (i.e. 0.02 µm <= 2.0 µm).

While reducing the production cost of the timepiece part, this configuration can provide the timepiece part with a particularly outstanding luster, aesthetic, scuff resistance and wear resistance. Outstanding durability can also be imparted to the timepiece part.

Further preferably, a timepiece part according to the invention preferably has a coating made from a material containing a fluorine-containing organosilicon compound disposed to the outside surface of the first coating.

This configuration can effectively prevent a drop in the appearance resulting from soiling. Furthermore, even if the timepiece part becomes soiled, the contamination can be more easily removed. An outstanding appearance can therefore be desirably maintained over a long period of time in many different environments. In addition to preventing soiling, this configuration also improves the feel and water resistance. Yet further, because fluorine-containing organosilicon compounds have little effect on the overall appearance of the timepiece part, timepiece parts can be more reliably given an outstanding appearance.

The timepiece part according to the invention is preferably a case member or band.

These parts (timepiece parts) contribute greatly to the overall appearance of the timepiece, and by applying the invention to such parts, a timepiece with an outstanding appearance overall can be achieved. Furthermore, these parts are generally exposed to the outside when the timepiece is being used and easily touch the skin, and such parts demand particularly outstanding scuff resistance, wear resistance, and hypoallergenicity (do not cause an allergic reaction). Therefore, by applying the invention to such parts, the effects of the invention described above are particularly enhanced.

Another aspect of the invention is a timepiece having a timepiece part according to the invention.

This configuration enables providing a timepiece having timepiece parts with an outstanding aesthetic appeal (providing particularly high luster and a luxurious appearance), outstanding corrosion resistance, and outstanding scuff resistance and abrasion resistance.

Other objects and attainments together with a fuller understanding of the invention will become apparent and appreciated by referring to the following description and claims taken in conjunction with the accompanying drawings.

### BRIEF DESCRIPTION OF THE DRAWINGS

FIG. 1 is a section view schematically illustrating a first embodiment of a timepiece part according to the invention.
FIG. 2 is a section view schematically illustrating a second embodiment of a timepiece part according to the invention.
FIG. 3 is a section view schematically illustrating a third embodiment of a timepiece part according to the invention.
FIG. 4 is a section view schematically illustrating a fourth embodiment of a timepiece part according to the invention.
FIG. 5 is a section view schematically illustrating a fifth embodiment of a timepiece part according to the invention.
FIG. 6 is a partial section view schematically illustrating a preferred embodiment of a timepiece (wristwatch) according to the invention.

### DESCRIPTION OF EMBODIMENTS

Preferred embodiments of the present invention are described below with reference to the accompanying figures.

### Timepiece parts

A timepiece part according to the invention is described first.

### Embodiment 1

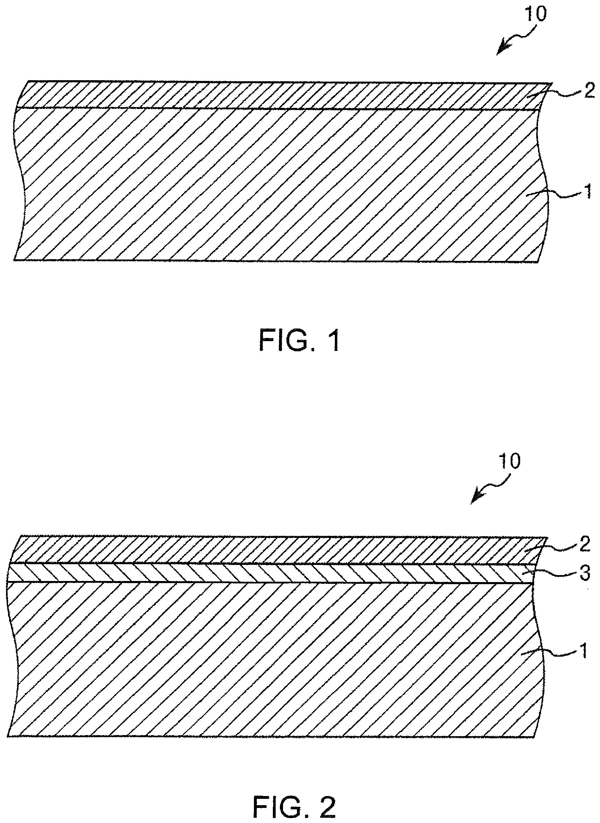

FIG. 1 is a section view schematically illustrating a first embodiment of a timepiece part according to the invention. A timepiece part according to the invention is described below supposing that the side shown on the top in FIG. 1 (and in FIG. 2 to FIG. 5) is the side that is exposed to (seen by) an observer.

A timepiece part 10 according to this embodiment has a substrate 1, and a first coating 2 comprising a material composed of Co, preferably primarily Co, i.e., Co as/being the main component/constituent and including greater than or equal to 26 wt% and less than or equal to 30 wt% Cr (i.e. 26 wt% <= 30 wt% Cr), and greater than or equal to 5 wt% and less than or equal to 7 wt% Mo (i.e. 5 wt% <= 7 wt% Mo).

This configuration enables providing a timepiece part 10 having an outstanding aesthetic appeal (providing particularly high luster and a luxurious appearance), outstanding corrosion resistance, and outstanding scuff resistance and abrasion resistance. More particularly, an appearance with high luster and a luxury feel can be obtained without using a precious metal as the main material. Timepiece parts with overall excellent aesthetic appearance can also be achieved using a variety of materials as the substrate 1, and the substrate 1 can be selected from a wide range of options. The materials of this first coating 2 are also hypoallergenic. Because a high luster, outstanding aesthetic can be achieved with a relatively thin first coating 2, the production cost of the timepiece part 10 can be suppressed, and the productivity of the timepiece part 10 is excellent.

Conversely, when the foregoing conditions are not met, the outstanding effect described above cannot be achieved.

For example, if the Cr wt% of the first coating 2 is less than the lower limit described above, corrosion resistance, scuff resistance, and abrasion resistance are deficient.

Furthermore, if the Cr wt% of the first coating 2 is greater than the upper limit described above, the aesthetic appeal drops, and a luxurious, high luster cannot be achieved.

Furthermore, if the Mo wt% of the first coating 2 is less than the lower limit described above, scuff resistance and abrasion resistance are deficient.

Furthermore, if the Mo wt% of the first coating 2 is greater than the upper limit described above, the aesthetic appeal drops, and a luxurious, high luster cannot be achieved.

Furthermore, if the first coating 2 is configured with Pt or other precious metal material instead of a coating composed of an alloy including Co, Cr and Mo, scuff resistance and abrasion resistance drop significantly.

### Substrate

The substrate 1 functions as a support member supporting the first coating 2.

The substrate 1 may be made from any desirable material, including, for example, metallic materials of alloys including at least one of A1, Ti, V, Cr, Fe, Co, Ni, Cu, Zn, Zr, Nb, Mo, In, Sn, Hf, Ta, W, Bi, Mg; ceramic materials including oxide ceramics such as alumina, zirconia, and titania, hydroxide ceramics such as hydroxyapatite, nitride ceramics such as silicon nitride, carbide ceramics such as silicon carbide, halide ceramics such as fluorite, carbonate ceramics, and phosphate ceramics; glass materials including sapphire glass, soda glass, crystalline glass, quartz glass, lead glass, potassium glass, borosilicate glass, and alkali-free glass; and plastics including thermoplastic resins and thermosetting resins.

Of these, the substrate 1 is preferably metal, and further preferably is a material including, preferably consisting of, at least one of stainless steel and Ti.

This enables achieving a substrate 1 with high strength and high corrosion resistance, excellent adhesion with the first coating 2, and a timepiece part 10 with excellent durability. When the first coating 2 is relatively thin, for example, this also desirably affects the overall appearance of the timepiece part 10, and a more reliably outstanding aesthetic in the timepiece part 10 overall. Because a sufficiently outstanding appearance can also be achieved even when the first coating 2 is relatively thin, this is advantageously helps suppress the production cost of the timepiece part 10.

Pure Ti or a Ti alloy (α alloy, α-β alloy, β alloy) may be used.

Ferritic, austenitic, martensitic, austenitic-ferritic, or other type of stainless steel may be used.

Of ferritic stainless steels, SUS-444 used the embodiments described below can be desirably used because it is a high purity ferritic stainless steel with ultra-low carbon, ultra-low nitrogen, 18% Cr, and 2% Mo content, outstanding pitting corrosion resistance, crevice corrosion resistance, and stress corrosion cracking resistance.

The stainless steel and Ti content of the substrate 1 is preferably greater than or equal to 95 wt%, and further preferably greater than or equal to 99 wt%.

This configuration greatly enhances the effects described above.

The content of precious metal elements (Au, Ag, Pt, Pd, Rh, Ir, Ru, Os) in the substrate 1 is preferably sufficiently low, and the content (if multiple precious metal elements are included, the total content of all) of precious metal elements in the substrate 1 is preferably less than or equal to 1.0 wt%, further preferably less than or equal to 0.5 wt%, and yet further preferably less than or equal to 0.1 wt%.

This configuration greatly enhances the effect of achieving an excellent appearance even without using a precious metal as the main material.

The substrate 1 may have a uniform composition throughout, or have parts with differing compositions. For example, the substrate 1 may be configured with a base and at least a single-layer film that covers the base and has a different composition than the base, or configured as a graded material in which the composition changes on a grade (for example, a graded material in which the composition changes on a slope through the thickness).

The shape and size of the substrate 1 are not specifically limited, and are usually based on the shape and size of the timepiece part 10.

The surface of the substrate 1 may also be processed to a mirror finish, brushed finish, or satin finish, for example. A raised or recessed pattern forming letters, numbers, symbols, or a graphic design may also be disposed to the substrate 1.

Such finishing processes enable imparting variations to the luster of the surface of the timepiece part 10, and can further improve the appearance of the timepiece part 10. A mirror finish can be achieved using a known polishing method, including mechanical polishing methods such as buffing and barreling. A mirror finish can be achieved using a known polishing method, including mechanical polishing methods such as buffing and barreling (barrel finishing).

Compared with parts produced by direct surface finishing of a coating, timepiece parts 10 manufactured using a substrate 1 that has already been surface finished has less glare and therefore a particularly outstanding appearance. The films (coatings) described below are normally relatively thin, and direct surface finishing of the coating can easily result in chipping, peeling, and other defects in the coating during the surface finishing process, and therefore significantly reduce yield in timepiece part 10 production, but these problems can be effectively prevented by applying surface finishing to the substrate 1. Surface processing the substrate 1 can also be done under milder conditions than surface processing the coatings described below.

### First coating

The first coating 2 is made of a material composed of Co, preferably primarily Co, i.e., Co as/being the main component/constituent, and including greater than or equal to 26 wt% and less than or equal to 30 wt% Cr (i.e. 26 wt% <= 30 wt% Cr), and greater than or equal to 5 wt% and less than or equal to 7 wt% Mo (i.e. 5 wt% <= 7 wt% Mo).

A first coating 2 made of such material has excellent luster and an outstanding appearance without comprising a precious metal. Corrosion resistance, scuff resistance, and wear resistance. The above first coating material preferably consists of the indicated amounts/ranges of Cr and Mo and optionally other components with a total content of less than or equal to 3.0 wt% (i.e. <= 3.0 wt%) and the remainder/rest being Co as the main component/constituent.

The first coating 2 is Co, preferably primarily Co, but the Co content of the first coating 2 is preferably greater than or equal to 55 wt% and less than or equal to 69 wt% (i.e. 55 wt% <= 69 wt%), further preferably greater than or equal to 62 wt% and less than or equal to 68 wt% (i.e. 62 wt% <= 68 wt%), and further preferably greater than or equal to 63 wt% and less than or equal to 67 wt% (i.e. 63 wt% <= 67 wt%).

This configuration enables an excellent balance with aesthetics and scuff and wear resistance.

The Cr content of the first coating 2 may be greater than or equal to 26 wt% and less than or equal to 30 wt% (i.e. 26 wt% <= 30 wt%), is preferably greater than or equal to 26.2 wt% and less than or equal to 29.8 wt% (i.e. 26.2 wt% <= 29.8 wt%), further preferably greater than or equal to 26.4 wt% and less than or equal to 29.6 wt% (i.e. 26.4 wt% <= 29.6 wt%), and yet further preferably greater than or equal to 26.6 wt% and less than or equal to 29.4 wt% (i.e. 26.6 wt% <= 29.4 wt%).

While maintaining an outstanding appearance, this configuration achieves outstanding corrosion resistance, scuff resistance, and wear resistance.

The Mo content of the first coating 2 may be greater than or equal to 5 wt% and less than or equal to 7 wt% (i.e. 5 wt% <= 7 wt%), but is preferably greater than or equal to 5.2 wt% and less than or equal to 6.8 wt% (i.e. 5.2 wt% <= 6.8 wt%), further preferably greater than or equal to 5.3 wt% and less than or equal to 6.7 wt% (i.e. 5.3 wt% <= 6.7 wt%), and yet further preferably greater than or equal to 5.4 wt% and less than or equal to 6.6 wt% (i.e. 5.4 wt% <= 6.6 wt%).

This configuration enables an excellent balance with aesthetics and scuff and wear resistance.

The first coating 2 may comprise components other that above. Examples of such components include Si, Mn, N, Fe, C, Ni, Ti, Al, Ag, Pt, Pd, Rh, Ir.

However, the content of components in the first coating 2 (if multiple components are included, the total content of all) other than Co, Cr, and Mo is preferably less than or equal to 3.0 wt% (i.e. <= 3.0 wt%), further preferably less than or equal to 2.0 wt% (i.e. <= 2.0 wt%), and yet further preferably less than or equal to 1.5 wt% (i.e. <= 1.5 wt%).

More particularly, the content of precious metal elements (Au, Ag, Pt, Pd, Rh, Ir, Ru, Os) in the first coating 2 (if multiple precious metal elements are included, the total content of all) is preferably less than or equal to 1.0 wt% (i.e. <= 1.0 wt%), further preferably less than or equal to 0.5 wt% (i.e. <= 0.5 wt%), and yet further preferably less than or equal to 0.1 wt% (i.e. <= 0.1 wt%).

This configuration greatly enhances the effect of achieving an excellent appearance even without using a precious metal as the main material.

The first coating 2 may have a uniform composition throughout, or have parts with differing compositions. For example, the first coating 2 may be configured as a laminate with multiple stacked layers, or configured as a graded material in which the composition changes on a grade (for example, a graded material in which the composition changes on a slope through the thickness). This configuration enables, while maintaining the effect of disposing the first coating 2 described above, even greater adhesion between the first coating 2 and substrate 1, and even greater durability in the timepiece part 10.

The thickness of the first coating 2 is preferably greater than or equal to 0.02 µm and less than or equal to 2.0 µm (i.e. 0.02 µm <= 2.0 µm), further preferably greater than or equal to 0.04 µm and less than or equal to 1.8 µm (i.e. 0.04 µm <= 1.8 µm), and yet further preferably greater than or equal to 0.07 µm and less than or equal to 1.6 µm (i.e. 0.07 µm <= 1.6 µm).

While suppressing the production cost of the timepiece part 10, this configuration can also achieve superior luster, appearance, scuff resistance and wear resistance in the overall timepiece part 10. Unintentional peeling of the first coating 2 can also be effectively prevented, and the durability of the timepiece part 10 can be further improved.

The method of forming the first coating 2 is not specifically limited and various coating methods, wet plating methods, chemical vapor deposition (CVD) methods, dry plating methods (vapor phase epitaxy), and spray coating methods can be used, but a dry plating method (vapor phase epitaxy) is preferred. Examples of coating methods include spin coating, dipping, brushing, spray coating, electrostatic coating, and electrodeposition coating. Wet plating methods include electrolytic plating, immersion plating, and electroless plating. CVD methods include thermal CVD, plasma CVD, and laser CVD methods. Dry plating methods include vacuum deposition, sputtering, ion plating, and laser ablation.

Using a dry plating method (vapor phase epitaxy) to form the first coating 2 enables reliably forming a homogenous first coating 2 with uniform film thickness and particularly outstanding adhesion with the substrate 1. The appearance and durability of the resulting timepiece part 10 are therefore particularly outstanding.

Furthermore, by using a dry plating method (vapor phase epitaxy) to form the first coating 2, unintentional variations in film thickness can be minimized even when the first coating 2 to be formed is relatively thin. This also helps improve the reliability of the timepiece part 10.

Furthermore, in the L*a*b* color chart defined in JIS Z 8729, for example, the color tone of the surface on the visible side of the first coating 2 of the substrate 1 (the surface on the side that is seen by the user when the timepiece part 10 is used) preferably has an a* of greater than or equal to -2.0 and less than or equal to 3.0 (i.e. -2.0 <= 3.0), and b* of greater than or equal to -1.0 and less than or equal to 10.0 (i.e. -1.0 <= 10.0), further preferably a* is greater than or equal to -1.5 and less than or equal to 2.5 (i.e. -1.5 <= 2.5) and b* is greater than or equal to 0.0 and less than or equal to 9.0 (i.e. 0.0 <= 9.0), and yet further preferably a* is greater than or equal to -1.0 and less than or equal to 2.0 (i.e. -1.0 <= 2.0) and b* is greater than or equal to 1.0 and less than or equal to 8.0 (i.e. 1.0 <= 8.0). The appearance of the timepiece part 10 is therefore particularly outstanding.

Furthermore, in the L*a*b* color chart defined in JIS Z 8729, for example, the color tone of the surface on the visible side of the first coating 2 of the substrate 1 (the surface on the side that is seen by the user when the timepiece part 10 is used) preferably has an L* of greater than or equal to 75.0 and less than or equal to 89.0 (i.e. 75.0 <= 89.0), further preferably L* is greater than or equal to 78.0 and less than or equal to 88.0 (i.e. 78.0 <= 88.0), and yet further preferably L* is greater than or equal to 82.0 and less than or equal to 87.0 (i.e. 82.0 <= 87.0). The appearance of the timepiece part 10 is therefore particularly outstanding.

The timepiece part 10 may be any desirable part of a timepiece, but is preferably a part that is visible from the outside when the timepiece is being used, may more particularly be the crystal, case member, bezel, back cover, wristband (including watch band links, the clasp, and the band-buckle coupling mechanism), dial, hands, rotor, crown (such as a screw down crown), button, dial ring, or dial cover or spacer, but is preferably a case member or band.

These parts (timepiece parts) contribute greatly to the overall appearance of the timepiece, and by applying the invention to such parts, a timepiece with an outstanding appearance overall can be achieved. Furthermore, these parts are generally exposed to the outside when the timepiece is being used and easily touch the skin, and such parts demand particularly outstanding scuff resistance, wear resistance, and hypoallergenicity (do not cause an allergic reaction). Therefore, by applying the invention to such parts, the effects of the invention described above are particularly enhanced.

### Embodiment 2

A timepiece part according to a second embodiment of the invention is described next.

FIG. 2 is a schematic section view of a timepiece part according to the second embodiment of the invention. The following description focuses particularly on the differences with the embodiment described above, and further description of like aspects is omitted.

A timepiece part 10 according to this embodiment has, disposed to the surface of the substrate 1, an underlayer 3 (first underlayer) made of a material containing Ti, preferably consisting of Ti as the main component/constituent and optionally further components, and then a first coating 2 comprising a material composed of Co, preferably primarily Co, i.e., as the main component/constituent, and including greater than or equal to 26 wt% and less than or equal to 30 wt% Cr (i.e. 26 wt% <= 30 wt% Cr) and greater than or equal to 5 wt% and less than or equal to 7 wt% Mo (i.e. 5 wt% <= 7 wt% Mo). In other words, the timepiece part 10 according to this embodiment has an underlayer 3 made of a material containing Ti between the substrate 1 and first coating 2.

This configuration enables even greater adhesion between the substrate 1 and first coating 2, can absorb impact to the timepiece part 10, and further improves the durability of the timepiece part 10. This configuration can also smooth the surface of the substrate 1, adjust subtle coloring of the entire timepiece part 10, and more reliably achieve an outstanding appearance in the timepiece part 10.

The underlayer 3 may also include components other than Ti.

However, the content of components other than Ti in the underlayer 3 is preferably less than or equal to 2.0 wt% (i.e. <= 2.0 wt%), further preferably less than or equal to 1.0 wt% (i.e. <= 1.0 wt%), and yet further preferably less than or equal to 0.5 wt% (i.e. <= 0.5 wt%).

More specifically, the content (if multiple precious metal elements are included, the total content of all) of precious metal elements (Au, Ag, Pt, Pd, Rh, Ir, Ru, Os) in the underlayer 3 is preferably less than or equal to 1.0 wt% (i.e. <= 1.0 wt%), further preferably less than or equal to 0.5 wt% (i.e. <= 0.5 wt%), and yet further preferably less than or equal to 0.1 wt% (i.e. <= 0.1 wt%).

The thickness of the underlayer 3 is preferably greater than or equal to 0.01 µm and less than or equal to 1.0 µm (i.e. 0.01 µm <= 1.0 µm), further preferably greater than or equal to 0.02 µm and less than or equal to 0.5 µm (i.e. 0.02 µm <= 0.5 µm), and yet further preferably greater than or equal to 0.03 µm and less than or equal to 0.3 µm (i.e. 0.03 µm <= 0.3 µm).

This configuration further enhances adhesion between the substrate 1 and first coating 2 and the impact absorption effect, further improves the durability of the timepiece part 10, further improves the productivity of the timepiece part 10, and effectively suppresses the timepiece part 10 production cost. This configuration can also smooth the surface of the substrate 1, adjust subtle coloring of the entire timepiece part 10, and more reliably achieve an outstanding appearance in the timepiece part 10. Smoothing the surface of the substrate 1, and adjusting subtle coloring of the entire timepiece part 10, can also be more desirably applied.

The method of forming the underlayer 3 is not specifically limited, and various coating methods, wet plating methods, chemical vapor deposition (CVD) methods, dry plating methods (vapor phase epitaxy), and spray coating methods can be used, but a dry plating method (vapor phase epitaxy) is preferred. Examples of coating methods include spin coating, dipping, brushing, spray coating, electrostatic coating, and electrodeposition coating. Wet plating methods include electrolytic plating, immersion plating, and electroless plating. CVD methods include thermal CVD, plasma CVD, and laser CVD methods. Dry plating methods include vacuum deposition, sputtering, ion plating, and laser ablation.

Using a dry plating method (vapor phase epitaxy) to form the underlayer 3 enables reliably forming a homogenous underlayer 3 with uniform film thickness and particularly outstanding adhesion with the substrate 1. The appearance and durability of the resulting timepiece part 10 are therefore particularly outstanding.

Furthermore, by using a dry plating method (vapor phase epitaxy) to form the underlayer 3, unintentional variations in film thickness can be minimized even when the underlayer 3 to be formed is relatively thin. This also helps improve the reliability of the timepiece part 10.

### Embodiment 3

A timepiece part according to a third embodiment of the invention is described next.

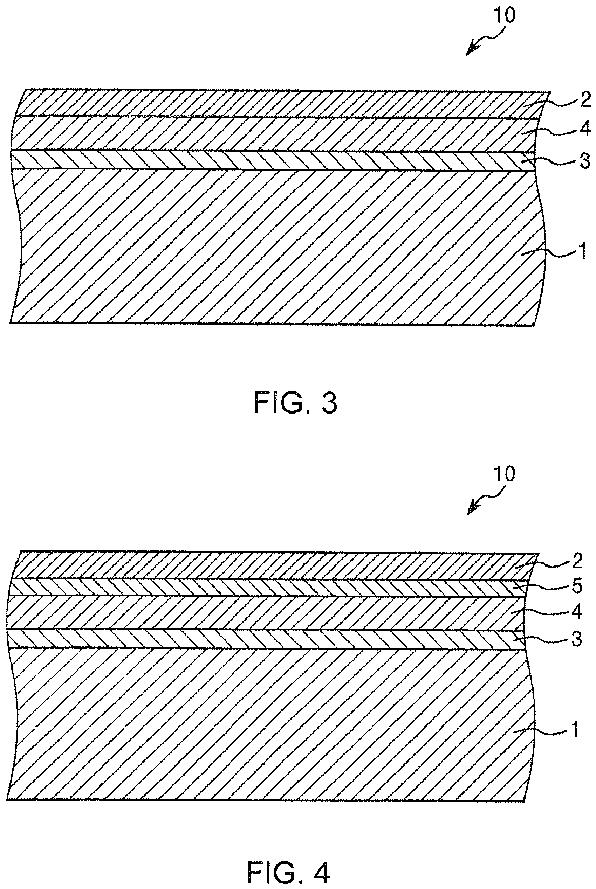

FIG. 3 is a schematic section view of a timepiece part according to the third embodiment of the invention. The following description focuses particularly on the differences with the embodiments described above, and further description of like aspects is omitted.

A timepiece part 10 according to this embodiment has, disposed to the surface of the substrate 1, an underlayer 3 (first underlayer) made of a material containing Ti, a second coating 4 made of a material including, preferably consisting of, at least one of TiC and TiCN, and a first coating 2 comprising a material of Co, preferably primarily Co, i.e., Co as/being the main component/constituent, and including greater than or equal to 26 wt% and less than or equal to 30 wt% Cr (i.e. 26 wt% <= 30 wt% Cr) and greater than or equal to 5 wt% and less than or equal to 7 wt% Mo (i.e. 5 wt% <= 7 wt% Mo) in this order. In other words, this timepiece part 10 is the same as the timepiece part 10 of the second embodiment other than having, between the substrate 1 and first coating 2, a second coating 4 made of a material including at least TiC or TiCN, preferably consisting of at least TiC or TiCN as the main component(s)/constituent(s) and optionally further components.

This configuration enables further increasing the hardness of the timepiece part 10, further enhancing the dent resistance (difficulty forming indentations) of the timepiece part 10, more effectively alleviating stress, and further improving the durability of the timepiece part 10. Coloring (particularly luster) can also be desirably adjusted.

The second coating 4 may also contain components other than TiC and TiCN.

However, the content of components other than TiC and TiCN in the second coating 4 is preferably less than or equal to 2.0 wt% (i.e. <= 2.0 wt%), further preferably less than or equal to 1.0 wt% (i.e. <= 1.0 wt%), and yet further preferably less than or equal to 0.5 wt% (i.e. <= 0.5 wt%).

More specifically, the content (if multiple precious metal elements are included, the total content of all) of precious metal elements (Au, Ag, Pt, Pd, Rh, Ir, Ru, Os) in the second coating 4 is preferably less than or equal to 1.0 wt% (i.e. <= 1.0 wt%), further preferably less than or equal to 0.5 wt% (i.e. <= 0.5 wt%), and yet further preferably less than or equal to 0.1 wt% (i.e. <= 0.1 wt%).

The second coating 4 may have a uniform composition throughout, or have parts with differing compositions. For example, the second coating 4 may be configured as a laminate of multiple stacked layers.

More particularly, the second coating 4 preferably has a part in which the composition changes on a slope through the thickness.

This configuration improves the dent resistance, scuff resistance, and abrasion resistance of the timepiece part 10, and achieves the coloring adjustment (particularly luster adjustment) effect of disposing the second coating 4 while further enhancing adhesion between the second coating 4 and parts adjacent to the second coating 4 (the underlayer 3 and first coating 2 in the configuration shown in the figure), more effectively prevents destruction of the second coating 4 (such as intralayer separation), and further improves the durability of the timepiece part 10.

The second coating 4 preferably has a region in which the total content of C and N decreases toward the surface of the second coating 4.

This configuration improves the dent resistance, scuff resistance, and abrasion resistance of the timepiece part 10, and achieves the coloring adjustment (particularly luster adjustment) effect of disposing the second coating 4 while further enhancing adhesion between the second coating 4 and parts adjacent to the second coating 4 (the underlayer 3 and first coating 2 in the configuration shown in the figure), more effectively prevents destruction of the second coating 4 (such as intralayer separation), and further improves the durability of the timepiece part 10.

The second coating 4 preferably has a region in which the total content of C and N decreases toward one surface of the second coating 4, but further preferably has regions in which the total content of C and N decreases toward both surfaces of the second coating 4.

This configuration improves adhesion between the second coating 4 and parts adjacent to both sides of the second coating 4 (the underlayer 3 and first coating 2 in the configuration shown in the figure), and further improves the durability of the timepiece part 10.

If the content of C and N in the region where the C and N content is greatest in the second coating 4 is X1 (wt%), and the content of C and N in the region where the C and N content is lowest in the second coating 4 is X2 (wt%), preferably 1 ≤ X1-X2 ≤ 20 (i.e. 1 <= X1-X2 <= 20), further preferably 2 ≤ X1-X2 ≤ 15 (i.e. 2 <= X1-X2 <= 15), and yet further preferably 3 ≤ X1-X2 ≤ 12 (i.e. 3 <= X1-X2 <= 12).

This further enhances the effects described above.

The thickness of the second coating 4 is preferably greater than or equal to 0.05 µm and less than or equal to 4.0 µm (i.e. 0.05 µm <= 4.0 µm), further preferably greater than or equal to 0.1 µm and less than or equal to 2.0 µm (i.e. 0.1 µm <= 2.0 µm), and yet further preferably greater than or equal to 0.2 µm and less than or equal to 1.5 µm (i.e. 0.2 µm <= 1.5 µm).

This configuration enables further increasing the hardness of the timepiece part 10, further enhancing the dent resistance (difficulty forming indentations) of the timepiece part 10, further improving the durability of the timepiece part 10, further improving the timepiece part 10 productivity, and effectively suppressing the timepiece part 10 production cost. Subtly adjusting the overall coloring of the timepiece part 10 can also be done more desirably.

Furthermore, disposing a underlayer 3 further improves adhesion between the substrate 1 and second coating 4, and further improves the durability of the timepiece part 10.

The method of forming the second coating 4 is not specifically limited, and various coating methods, wet plating methods, chemical vapor deposition (CVD) methods, dry plating methods (vapor phase epitaxy), and spray coating methods can be used, but a dry plating method (vapor phase epitaxy) is preferred. Examples of coating methods include spin coating, dipping, brushing, spray coating, electrostatic coating, and electrodeposition coating. Wet plating methods include electrolytic plating, immersion plating, and electroless plating. CVD methods include thermal CVD, plasma CVD, and laser CVD methods. Dry plating methods include vacuum deposition, sputtering, ion plating, and laser ablation.

Furthermore, by using a dry plating method (vapor phase epitaxy) to form the second coating 4, a homogenous second coating 4 with uniform film thickness and particularly outstanding adhesion with the underlayer 3 can be formed. The appearance and durability of the resulting timepiece part 10 are therefore particularly outstanding.

Furthermore, by using a dry plating method (vapor phase epitaxy) to form the second coating 4, unintentional variations in film thickness can be minimized even when the second coating 4 to be formed is relatively thin. This also helps improve the reliability of the timepiece part 10.

The second coating 4 described above can also be applied to the first embodiment and achieve the same effect.

### Embodiment 4

A timepiece part according to a fourth embodiment of the invention is described next.

FIG. 4 is a schematic section view of a timepiece part according to the fourth embodiment of the invention. The following description focuses particularly on the differences with the embodiments described above, and further description of like aspects is omitted.

A timepiece part 10 according to this embodiment has, disposed to the surface of the substrate 1, an underlayer 3 (first underlayer) made of a material containing Ti, a second coating 4 made of a material including at least one of TiC and TiCN, an underlayer 5 (second underlayer) made of a material containing, preferably consisting of, Ti, and a first coating 2 comprising a material composed of Co, preferably primarily Co, i.e., Co as/being the main component/constituent, and including greater than or equal to 26 wt% and less than or equal to 30 wt% Cr (i.e. 26 wt% <= 30 wt% Cr) and greater than or equal to 5 wt% and less than or equal to 7 wt% Mo (i.e. 5 wt% <= 7 wt% Mo) in this order. In other words, in this embodiment a second coating 4 made of a material including at least one of TiC and TiCN is disposed between the substrate 1 and first coating 2, and a underlayer 3, 5 is disposed on each side of the second coating 4.

This configuration enhances adhesion between the substrate 1 and second coating 4, also enhances adhesion between the second coating 4 and first coating 2, enables more effectively absorbing impact to the timepiece part 10, and yet further enhances the durability of the timepiece part 10. This configuration can also smooth the surface of the second coating 4, adjust subtle coloring of the entire timepiece part 10, and more reliably achieve an outstanding appearance in the timepiece part 10.

The underlayer 5 may also include components other than Ti. Preferably, the underlayer 5 consists of Ti as the main component/constituent and optionally further components.

However, the content of components other than Ti in the underlayer 5 is preferably less than or equal to 2.0 wt% (i.e. <= 2.0 wt%), further preferably less than or equal to 1.0 wt% (i.e. <= 1.0 wt%), and yet further preferably less than or equal to 0.5 wt% (i.e. <= 0.5 wt%).

More specifically, the content (if multiple precious metal elements are included, the total content of all) of precious metal elements (Au, Ag, Pt, Pd, Rh, Ir, Ru, Os) in the underlayer 5 is preferably less than or equal to 1.0 wt% (i.e. <= 1.0 wt%), further preferably less than or equal to 0.5 wt% (i.e. <= 0.5 wt%), and yet further preferably less than or equal to 0.1 wt% (i.e. <= 0.1 wt%).

The thickness of the underlayer 5 is preferably greater than or equal to 0.01 µm and less than or equal to 1.0 µm (i.e. 0.01 µm <= 1.0 µm), further preferably greater than or equal to 0.02 µm and less than or equal to 0.5 µm (i.e. 0.02 µm <= 0.5 µm), and yet further preferably greater than or equal to 0.03 µm and less than or equal to 0.3 µm (i.e. 0.03 µm <= 0.3 µm).

This configuration further enhances adhesion between the second coating 4 and first coating 2 and the impact absorption effect, further improves the durability of the timepiece part 10, further improves the productivity of the timepiece part 10, and effectively suppresses the timepiece part 10 production cost. This configuration can also smooth the surface of the second coating 4, and enable more desirably adjusting subtle coloring of the entire timepiece part 10.

The method of forming the underlayer 5 is not specifically limited, and various coating methods, wet plating methods, chemical vapor deposition (CVD) methods, dry plating methods (vapor phase epitaxy), and spray coating methods can be used, but a dry plating method (vapor phase epitaxy) is preferred. Examples of coating methods include spin coating, dipping, brushing, spray coating, electrostatic coating, and electrodeposition coating. Wet plating methods include electrolytic plating, immersion plating, and electroless plating. CVD methods include thermal CVD, plasma CVD, and laser CVD methods. Dry plating methods include vacuum deposition, sputtering, ion plating, and laser ablation.

Using a dry plating method (vapor phase epitaxy) to form the underlayer 5 enables reliably forming a homogenous underlayer 5 with uniform film thickness and particularly outstanding adhesion with the second coating 4. The appearance and durability of the resulting timepiece part 10 are therefore particularly outstanding.

Furthermore, by using a dry plating method (vapor phase epitaxy) to form the underlayer 5, unintentional variations in film thickness can be minimized even when the underlayer 5 to be formed is relatively thin. This also helps improve the reliability of the timepiece part 10.

### Embodiment 5

A timepiece part according to a fifth embodiment of the invention is described next.

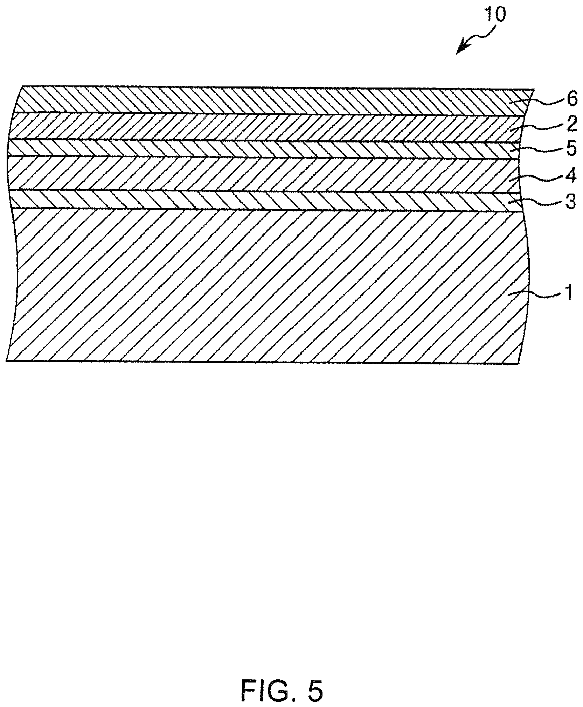

FIG. 5 is a schematic section view of a timepiece part according to the fifth embodiment of the invention. The following description focuses particularly on the differences with the embodiment described above, and further description of like aspects is omitted.

A timepiece part 10 according to this embodiment has, disposed to the surface of the substrate 1, an underlayer 3 (first underlayer) made of a material containing Ti, a second coating 4 made of a material including at least one of TiC and TiCN, an underlayer 5 (second underlayer) made of a material containing Ti, a first coating 2 comprising a material composed of Co, preferably primarily Co, i.e., Co as/being the main component/constituent, and including greater than or equal to 26 wt% and less than or equal to 30 wt% Cr (i.e. 26 wt% <= 30 wt% Cr) and greater than or equal to 5 wt% and less than or equal to 7 wt% Mo (i.e. 5 wt% <= 7 wt% Mo), and a coating 6 made from a material containing, preferably consisting of, a fluorine-containing organosilicon compound, in this order. In other words, this embodiment is the same as the fourth embodiment other than having, disposed to the outside surface of the first coating 2, a coating 6 made from a material containing, preferably consisting of, a fluorine-containing organosilicon compound.

This configuration can effectively prevent a drop in the appearance resulting from soiling. Furthermore, even if the timepiece part 10 becomes soiled, the contamination can be more easily removed. An outstanding appearance can therefore be desirably maintained over a long period of time in many different environments. In addition to preventing soiling, providing a coating 6 made from a material containing a fluorine-containing organosilicon compound also improves the feel and water resistance. Yet further, because fluorine-containing organosilicon compounds have little effect on the overall appearance of the timepiece part 10, timepiece parts 10 can be more reliably given an outstanding appearance.

Specific examples of fluorine-containing organosilicon compounds include: CF₃ (CF₂)₂C₂H₄Si (OCH₃)₃, CF₃ (CF₂)₄C₂H₄Si (OCH₃)₃, CF₃ (CF₂)₆C₂H₄Si (OCH₃)_{3,} CF₃ (CF₂)₈C₂H₄Si (OCH₃)₃, CF₃ (CF₂) ₁₀C₂H₄Si (OCH₃)₃, CF₃ (CF₂)₁₂C₂H₄Si (OCH₃)₃, CF₃ (CF₂)₁₄C₂H₄Si (OCH₃)₃, CF₃ (CF₂)₁₆C₂H₄Si (OCH₃)₃, CF₃ (CF₂)₁₈C₂H₄Si (OCH₃)₃, CF₃ (CF₂)₆C₂H₄Si (OC₂H₅)₃, CF₃ (CF₂)₈C₂H₄Si (OC₂H₅)₃, CF₃ (CF₂)₆C₂H₄SiCl₃, CF₃ (CF₂)₈C₂H₄SiCl₃, CF₃ (CF₂)₆C3H₆Si (OCH₃)₃, CF₃ (CF₂)₈C₃H₆Si (OCH₃)₃, CF₃ (CF₂)₆C₃H₆Si (OC₂H₅)₃, CF₃ (CF₂)₈C₃H₆Si (OC₂H₅)₃, CF₃ (CF₂)₆C₃H₆SiCl₃, CF₃ (CF₂)₈C₃H₆SiCl₃, CF₃ (CF₂)₆C₄H₈Si (OCH₃)₃, CF₃ (CF₂)₈C₄H₈Si (OCH₃)₃, CF₃ (CF₂)₆C₄H₈Si (OC₂H₅)₃, CF₃ (CF₂)₈C₄H₈Si (OC₂H₅)₃, CF₃ (CF₂)₆C₂H₄Si (CH₃) (OCH₃)₂, CF₃ (CF₂)₈C₂H₄Si (CH₃) (OCH₃)₂, CF₃ (CF₂)₆C₂H₄Si (CH₃)Cl₂, CF₃ (CF₂)₈C₂H₄Si (CH₃)Cl₂, CF₃ (CF₂)₆C₂H₄Si (C₂H₅) (OC₂H₅)₂, CF₃ (CF₂)₈C₂H₄Si (C₂H₅) (OC₂H₅)₂.

Compounds containing an amino group can also be desirably used as a fluorine-containing organosilicon compound.

Examples of fluorine-containing organosilicon compounds containing an amino group include, for example: C₉F₁₉CONH (CH₂)₃Si (OC₂H₅)₃, C₉F₁₉CONH (CH₂)₃SiCl₃, C₉F₁₉CONH (CH₂)₃Si (CH₃)Cl₂, C₉F₁₉CONH (CH₂)NH (CH₂)Si (OC₂H₅)₃, C₉F₁₉CONH (CH₂)₅CONH (CH₂)Si (OC₂H₅)₃, C₈F₁₇SO₂NH (CH₂)₅CONH (CH₂)Si (OC₂H₅)₃, C₃F₇O (CF (CF₃)CF₂O)₂-CF (CF₃)-CONH (CH₂)Si (OC₂H₅)₃, C₃F₇O (CF (CF₃)CF₂O)_{m'}-CF (CF₃)-CONH (CH₂)Si (OCH₃)₃ (where m' is an integer of 1 or more).

In addition, R_{f}' (CH₂)₂SiCl₃, R_{f}' (CH₂)₂Si (CH₃)Cl₂, (R_{f}'CH₂CH₂)₂SiCl₂, R_{f}' (CH₂)₂Si (OCH₃)₃, R_{f}'CONH (CH₂)₃Si (OC₂H₅)₃, R_{f}'CONH (CH₂)₂NH (CH₂)₃Si (OC₂H₅)₃, R_{f}'SO₂N (CH₃) (CH₂)₂CONH (CH₂)₃Si (OC₂H₅)₃, R_{f}' (CH₂)₂OCO (CH₂)₂S (CH₂)₃Si (OCH₃)₃, R_{f}' (CH₂)₂OCONH (CH₂)₂Si (OC₂H₅)₃, R_{f}' COO-Cy (OH)- (CH₂)₂Si (OCH₃)₃, R_{f}' (CH₂)₂NH (CH₂)₂Si (OCH₃)₃, and R_{f}' (CH₂)₂NH (CH₂)₂NH (CH₂)₂Si (OCH₂CH₂OCH₃)₃ may be used for the fluorine-containing organosilicon compound. In these formulas, Cy is a cyclohexane residue, and R_{f}' is a polyfluoroalkyl group with greater than or equal to 4 and less than or equal to 16 carbon atoms (i.e. 4 <= 16 C).

Compounds described by formula (1) and formula (2) below are preferably used as the fluorine-containing organosilicon compound in the coating 6.

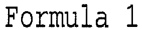

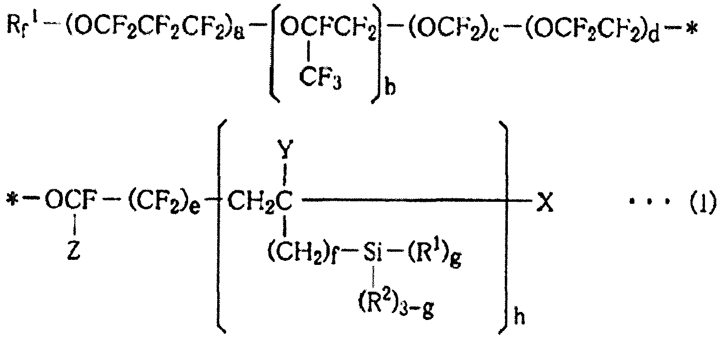

In formula (1), R_{f}¹ is a perfluoroalkyl group; X denotes bromine, iodine, or hydrogen; Y denotes hydrogen or a lower alkyl group; Z denotes fluorine or a trifluoromethyl group; R¹ denotes hydrolyzable group; R² denotes hydrogen or an inert univalent hydrocarbon radical; a, b, c, d, e are integers of 0, 1 or more where a+b+c+d+e is at least greater than or equal to 1, and the order of units enclosed by a, b, c, d, e is not limited to that shown in the formula; f is 0, 1, or 2; g is 1, 2, or 3; and h is an integer of 1 or more.

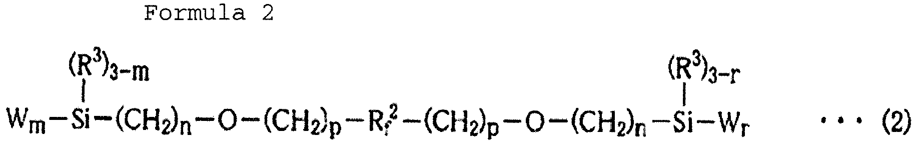

In formula (2), R_{f}² denotes a bivalent group with a non-branching, straight-chain perfluoroalkylene ether structure containing units denoted (- (CₖF₂ₖ) O-). In the formula (- (CₖF₂ₖ)O-), k is an integer of greater than or equal to 1 and less than or equal to 6 (i.e. 1 <= 6). R³ denotes a univalent hydrocarbon radical containing 1 to 8 C; W denotes a hydrolyzable group or a halogen atom; p is 0, 1, or 2; n is an integer greater than or equal to 1 and less than or equal to 5 (i.e. 1 <= 5); and m and r are 2 or 3.

The thickness of the coating 6 is preferably greater than or equal to 0.01 µm and less than or equal to 1.0 µm (i.e. 0.01 µm <= 1.0 µm), further preferably greater than or equal to 0.02 µm and less than or equal to 0.5 µm (i.e. 0.02 µm <= 0.5 µm), and yet further preferably greater than or equal to 0.03 µm and less than or equal to 0.3 µm (i.e. 0.03 µm <= 0.3 µm).

This coating 6 can be applied to any of embodiments 1 to 3 described above, achieving the same effects.

### Timepiece

A timepiece according to the invention is described next.

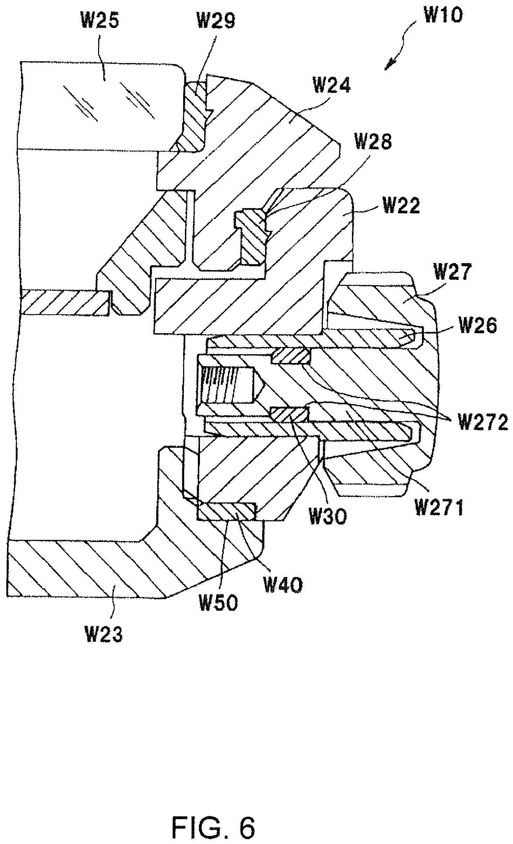

FIG. 6 is a partial section view of a preferred embodiment of a timepiece (wristwatch) according to the invention.

A wristwatch (timepiece) W10 according to this embodiment has a case W22, back cover W23, bezel W24, and crystal W25. A movement not shown (such as an analog movement with a dial and hands) is housed inside the case W22.

A stem pipe W26 is inserted and fixed in the case W22, and the stem W271 of the crown W27 is rotatably inserted to the stem pipe W26.

The bezel W24 is fastened to the case W22 by plastic packing W28, and the crystal W25 is secured to the bezel W24 by plastic packing W29.

The back cover W23 is pressed (or screwed) to the case W22 with a ring-shaped rubber packing (back cover packing) W40 compressed in the connection (seal) W50 between the case W22 and back cover W23. This configuration produces a watertight seal at the connection W50, making the wristwatch W10 water resistant.

A channel W272 is formed around the outside circumference in the middle of the stem W271 of the crown W27, and a ring-shaped rubber packing (crown packing) W30 is fit into this channel W272. The rubber packing W30 fits tightly to the inside surface of the stem pipe W26, and is compressed between this inside circumference surface and the inside surface of the channel W272. A watertight seal is thereby created between the crown W27 and the stem pipe W26, making the wristwatch W10 water resistant. Note that when the crown W27 is turned, the rubber packing W30 turns with the stem W271 and slides circumferentially against the inside circumference surface of the stem pipe W26.

In the wristwatch W10 in this embodiment of a wristwatch according to the invention, at least one of these parts is a timepiece part according to the invention as described above. In other words, a timepiece according to the invention includes a timepiece part according to the invention.

This configuration enables providing a timepiece W10 having timepiece parts with an outstanding aesthetic appeal (providing particularly high luster and a luxurious appearance), outstanding corrosion resistance, and outstanding scuff resistance and abrasion resistance.

Preferred embodiments of the invention are described above, but the invention is not limited thereto.

For example, in a timepiece part and timepiece according to the invention, the configuration of individual parts can be replaced by desired configurations exhibiting the same function, and other desired configurations can be added.

For example, the timepiece parts may have an underlayer made of a material other than Ti, and may have a coating layer made of a material other than a fluorine-containing organosilicon compound.

In addition, the foregoing embodiments are described assuming that when the timepiece part is in use, the observer (user) sees the side of the timepiece part to which the first coating is disposed, but if the substrate is made from a transparent material, for example, the observer may see the opposite side. In other words, the first coating 2 may be visible through the substrate.

### [Examples]

Specific examples of the invention are described below.

### 1. Manufacturing a timepiece part

### (Example 1)

A substrate of pure Ti having the desired shape of the wristwatch case was first prepared.

This substrate was then cleaned. The substrate was cleaned by electrolytic alkaline degreasing for 30 seconds followed by neutralization for 10 seconds, a water wash for 10 seconds, and a demineralized water wash for 10 seconds.

A 0.5 µm thick first coating made from a CoCrMo alloy was then formed on the surface of the substrate by sputtering, acquiring the timepiece case as a timepiece part. The power was set to 9 kW and the bias voltage to -120 V when forming the first coating.

### (Example 2)

A timepiece part (timepiece case) was manufactured as in example 1 except for using SUS 444, a ferritic stainless steel, as the substrate.

### (Example 3)

A substrate of pure Ti having the desired shape of the wristwatch case was first prepared.

This substrate was then cleaned. The substrate was cleaned by electrolytic alkaline degreasing for 30 seconds followed by neutralization for 10 seconds, a water wash for 10 seconds, and a demineralized water wash for 10 seconds.

A 0.1 µm thick Ti underlayer (first underlayer) was then formed on the surface of the substrate by sputtering. The power was set to 9 kW and the bias voltage to -80 V when forming the underlayer.

A 0.5 µm thick first coating made from a CoCrMo alloy was then formed on the surface of the underlayer by sputtering, acquiring the timepiece case as a timepiece part. The power was set to 9 kW and the bias voltage to -120 V when forming the first coating.

### (Example 4)

The timepiece part (timepiece case) in this example was produced in the same way as Example 3 except for using a SUS 444 substrate, and changing the composition of the CoCrMo alloy used as the target to form the first coating.

### (Example 5)

A substrate of pure Ti having the desired shape of the wristwatch case was first prepared.

This substrate was then cleaned. The substrate was cleaned by electrolytic alkaline degreasing for 30 seconds followed by neutralization for 10 seconds, a water wash for 10 seconds, and a demineralized water wash for 10 seconds.

A 0.1 µm thick Ti underlayer was then formed on the surface of the substrate by sputtering. The power was set to 9 kW and the bias voltage to -80 V when forming the underlayer.

A 0.35 µm thick second coating made of TiC was then formed on the surface of the underlayer by sputtering. The power was set to 9 kW and the bias voltage to -80 V when forming the second coating.

A 0.5 µm thick first coating made from a CoCrMo alloy was then formed on the surface of the underlayer by sputtering, acquiring the timepiece case as a timepiece part. The power was set to 9 kW and the bias voltage to -120 V when forming the first coating.

### (Example 6)

The timepiece part (timepiece case) in this example was produced in the same way as Example 5 except for using a SUS 444 substrate, and changing the composition of the CoCrMo alloy used as the target to form the first coating.

### (Example 7)

A substrate of pure Ti having the desired shape of the wristwatch case was first prepared.

This substrate was then cleaned. The substrate was cleaned by electrolytic alkaline degreasing for 30 seconds followed by neutralization for 10 seconds, a water wash for 10 seconds, and a demineralized water wash for 10 seconds.

A 0.1 µm thick Ti first underlayer was then formed on the surface of the substrate by sputtering. The power was set to 9 kW and the bias voltage to -80 V when forming the first underlayer.

A 0.50 µm thick second coating made of TiC was then formed on the surface of the first underlayer by sputtering. The power was set to 9 kW, the bias voltage to -80 V, and the argon flow to 100 ccm, when forming the second coating. By then increasing the acetylene flow from 10 ccm to 20 ccm, and then decreasing the acetylene flow from 20 ccm to 10 ccm, the second coating was formed as a graded material in which the total content of C and N near the center of the thickness is high, and the total content of C and N decreases therefrom toward the opposite surfaces.

A 0.05 µm thick Ti second underlayer was then formed on the surface of the substrate second coating by sputtering. The power was set to 9 kW and the bias voltage to -80 V when forming the second underlayer.

A 0.5 µm thick first coating made from a CoCrMo alloy was then formed on the surface of the second underlayer by sputtering, acquiring the timepiece case as a timepiece part. When forming the first coating, and the power was changed over time from 1 kW to 9 kW, the bias voltage was changed over time from -80 V to -120 V, thereby forming the first coating as a graded material in which the composition and film properties change on a slope through the thickness.

### (Example 8)

The timepiece part (timepiece case) in this example was produced in the same way as Example 7 except for using a SUS 444 substrate, and changing the configuration as shown in Table 1 by changing the film formation time of each film (layer).

### (Example 9)

A substrate of pure Ti having the desired shape of the wristwatch case was first prepared.

This substrate was then cleaned. The substrate was cleaned by electrolytic alkaline degreasing for 30 seconds followed by neutralization for 10 seconds, a water wash for 10 seconds, and a demineralized water wash for 10 seconds.

A 0.1 µm thick Ti first underlayer was then formed on the surface of the substrate by sputtering. The power was set to 9 kW and the bias voltage to -80 V when forming the first underlayer.

A 0.35 µm thick second coating made of TiC was then formed on the surface of the first underlayer by sputtering. The power was set to 9 kW, the bias voltage to -80 V, and the argon flow set to 100 ccm, when forming the second coating.

A 0.05 µm thick Ti second underlayer was then formed on the surface of the substrate second coating by sputtering. The power was set to 9 kW and the bias voltage to -80 V when forming the second underlayer.

A 0.5 µm thick first coating made from a CoCrMo alloy was then formed on the surface of the second underlayer by sputtering. The power was set to 9 kW and the bias voltage to -120 V when forming the first coating.

A 0.03 µm thick coating made of a fluorine-containing organosilicon compound was then formed on the surface of the first coating, acquiring a timepiece case as the timepiece part.

First, a fluorine-containing organosilicon compound (Shin-Etsu Chemical, KY-130 (3)) was diluted with a fluorine-based solvent (Shin-Etsu Chemical, FR Thinner) to 3 wt% solid content, of which 1.0 g of was then loaded into a container (copper cylinder with an open top, 16 mm inside diameter x 6 mm inside height) that was previously loaded with 0.5 g steel wool (Nihon Steel Wool, #0, 0.025 mm fiber diameter), and then dried for 1 hour at 120°C. Next, the copper container and substrate on which the first underlayer, second coating, second underlayer, and first coating were formed were placed in a vacuum evaporator, the evaporator set to 0.01 Pa, and the fluorine-containing organosilicon compound evaporated from the copper vessel to achieve a film formation rate (evaporation rate) of 0.6 Å/s. A molybdenum resistance heating boat was used as the heating source.

### (Example 10)

The timepiece part (timepiece case) in this example was produced in the same way as Example 9 except for using a SUS 444 substrate.

### (Comparison 1)

A timepiece part (timepiece case) was manufactured in the same way as Example 1 except for forming Pt film instead of the first coating made from a CoCrMo alloy.

### (Comparisons 2 - 5)

Timepiece parts (timepiece case) were manufactured in the same way as Example 1 except for changing the composition of the CoCrMo alloy used as the target for forming the first coating.

The composition of the timepiece parts in the examples and comparisons are shown in Table 1. Note that the conditions of the film made from Pt in Comparison 1 are shown in the first coating column. The content of the components (total content of multiple components) in the first coating other than those shown in Table 1 is less than or equal to 1.5 wt% in each example and the comparisons. In each part of the timepiece part, the content of all components shown in the Table is less than or equal to 99.9 wt%.

### Table 1

**Table 1**

| | Substrate | First underlayer | | Second coating | | Second underlayer | | First coating | | | | | Coating | |
|---|---|---|---|---|---|---|---|---|---|---|---|---|---|---|
| | Material | Material | Thickness (µm) | Material | Thickness (µm) | Material | Thickness (µm) | Material | | | | Thick -ness (µm) | Material | Thickness (µm) |
| | | | | | | | | Co (wt% ) | Cr (wt% ) | Mo (wt% ) | Pt (wt% ) | | | |
| Example 1 | Ti | | | | | | | bal | 28.2 | 6.0 | 0 | 0.5 | | |
| Example 2 | SUS444 | | | | | | | bal | 28.2 | 6.0 | 0 | 0.5 | | |
| Example 3 | Ti | Ti | 0.1 | | | | | bal | 26.6 | 6.2 | 0 | 0.5 | | |
| Example 4 | SUS444 | Ti | 0.1 | | | | | bal | 29.4 | 5.5 | 0 | 0.5 | | |
| Example 5 | Ti | Ti | 0.1 | TiC | 0.35 | | | bal | 28.8 | 5.4 | 0 | 0.5 | | |
| Example 6 | SUS444 | Ti | 0.1 | TiC | 0.35 | | | bal | 27.7 | 6.6 | 0 | 0.5 | | |
| Example 7 | Ti | Ti | 0.1 | TiC | 0.50 | Ti | 0.05 | bal | 28.2 | 6.0 | 0 | 0.5 | | |
| Example 8 | SUS444 | Ti | 0.3 | TiC | 0.85 | Ti | 0.2 | bal | 28.5 | 5.8 | 0 | 1.0 | | |
| Example 9 | Ti | Ti | 0.1 | TiC | 0.35 | Ti | 0.05 | bal | 28.1 | 6.1 | 0 | 0.5 | fluorine-containing organosilicon compound | 0.03 |
| Example 10 | SUS444 | Ti | 0.1 | TiC | 0.35 | Ti | 0.05 | bal | 28.1 | 6.1 | 0 | 0.5 | fluorine-containing organosilicon compound | 0.03 |
| Comparison 1 | Ti | | | | | | | 0 | 0 | 0 | 100 | 0.5 | | |
| Comparison 2 | Ti | | | | | | | bal | 26.1 | 26.1 | 0 | 0.5 | | |
| Comparison 3 | Ti | | | | | | | bal | 30.3 | 30.3 | 0 | 0.5 | | |
| Comparison 4 | Ti | | | | | | | bal | 28.2 | 28.2 | 0 | 0.5 | | |
| Comparison 5 | Ti | | | | | | | bal | 28.2 | 28.2 | 0 | 0.5 | | |

### [2] Evaluation

### [2-1] Visual evaluation

The appearance of the timepiece parts manufactured as described in the examples and comparisons above was inspected visually and by microscope, and graded as described below.
A: extremely outstanding appearance exuding luxury with a high luster
B: excellent appearance exuding luxury with a high luster
C: outstanding appearance exuding high quality with high luster
D: somewhat inferior appearance with luster
E: poor appearance with low luster

### [2-2] Evaluation by spectrophotometer

### [2-2-1] Evaluation based on a* and b* values

Timepiece parts manufactured as described in the examples and comparisons above were inspected using a spectrophotometer (Konica Minolta, CM-5), and graded as described below.
A: In the L*a*b* color chart defined in JIS Z 8729, a* is greater than or equal to -1.0 and less than or equal to 2.0 (i.e. - 1.0 <= 2.0) and b* is greater than or equal to 1.0 and less than or equal to 8.0 (i.e. 1.0 <= 8.0).
B: In the L*a*b* color chart defined in JIS Z 8729, a* is greater than or equal to -1.5 and less than or equal to 2.5 (i.e. - 1.5 <= 2.5) and b* is greater than or equal to 0.0 and less than or equal to 9.0 (i.e. 0.0 <= 9.0) (not including range A).
C: In the L*a*b* color chart defined in JIS Z 8729, a* is greater than or equal to -2.0 and less than or equal to 3.0 (i.e. - 2.0 <= 3.0) and b* is greater than or equal to -1.0 and less than or equal to 10.0 (i.e. -1.0 <= 10.0) (not including ranges A and B).
D: In the L*a*b* color chart defined in JIS Z 8729, a* is greater than or equal to -3.0 and less than or equal to 4.0 (i.e. - 3.0 <= 4.0) and b* is greater than or equal to -2.0 and less than or equal to 11.0 (i.e. -2.0 <= 11.0) (not including ranges A, B, and C).
E: In the L*a*b* color chart defined in JIS Z 8729, a* is greater than or equal to -3.0 and less than or equal to 4.0 (i.e. - 3.0 <= 4.0) and b* is outside the range greater than or equal to - 2.0 and less than or equal to 11.0 (i.e. -2.0 <= 11.0).

A D65 light source as defined by JIS Z 8720 was used as the light source of the spectrophotometer, and the viewing angle was 2°.

### [2-2-2] Evaluation based on L* value

Timepiece parts manufactured as described in the examples and comparisons above were inspected using a spectrophotometer (Konica Minolta, CM-5), and graded as described below.
A: In the L*a*b* color chart defined in JIS Z 8729, L* was greater than or equal to 82.0 and less than or equal to 87.0 (i.e. 82.0 <= 87.0).
B: In the L*a*b* color chart defined in JIS Z 8729, L* was greater than or equal to 78.0 and less than or equal to 88.0 (i.e. 78.0 <= 88.0) (not including range A).
C: In the L*a*b* color chart defined in JIS Z 8729, L* was greater than or equal to 75.0 and less than or equal to 89.0 (i.e. 75.0 <= 89.0) (not including ranges A and B).
D: In the L*a*b* color chart defined in JIS Z 8729, L* was greater than or equal to 74.0 and less than or equal to 90.0 (i.e. 74.0 <= 90.0) (not including ranges A, B, and C).
E: In the L*a*b* color chart defined in JIS Z 8729, L* was outside the range greater than or equal to 74.0 and less than or equal to 90.0 (i.e. 74.0 <= 90.0).

A D65 light source as defined by JIS Z 8720 was used as the light source of the spectrophotometer, and the viewing angle was 2°.

### [2-3] Corrosion resistance

Artificial sweat was placed in a desiccator, and left for 12 hours at 45°C. The timepiece parts were placed so as not to be submerged in the artificial sweat. After 120 hours, the timepiece parts were removed from the desiccator, the timepiece parts were measured using a spectrophotometer (Konica Minolta, CM-5, the color difference before and after the above aeration test to obtain the color difference, which was then graded as follows.
A: color difference ΔE is less than 3 (i.e. ΔE < 3)
B: color difference ΔE is greater than or equal to 3 and less than 4 (i.e. 3 <= ΔE < 4)
C: color difference ΔE is greater than or equal to 4 and less than 5 (i.e. 4 <= ΔE < 5)
D: color difference ΔE is greater than or equal to 5 and less than 6 (i.e. 5 <= ΔE < 6)
E: color difference ΔE is greater than or equal to 6 (i.e. ΔE >= 6)

A D65 light source as defined by JIS Z 8720 was used as the light source of the spectrophotometer, and the viewing angle was 2°.

### [2-4] Scuff resistance, abrasion resistance

The scuff resistance and abrasion resistance of the above examples and comparisons were tested and evaluated as described below.

Using a Suga abrasion tester (Suga Test Instruments, NUS-ISO-1) set to a 200 gf load, the surface of each timepiece part was abraded a total 300 DS (double strokes), the appearance was then visually observed, and evaluated as described below. The test was conducted using a Sumitomo 3M lapping film (aluminum oxide, 30 µm grain size)
A: no observable marks on the surface
B: substantially no observable marks on the surface
C: some observable marks on the surface
D: significant marking observable on the surface, or peeling of the coating (first coating, coating layer) observed

### [2-5] Dent resistance

The dent resistance of the above examples and comparisons was tested and evaluated as described below.

A stainless steel ball (1 cm diameter) was dropped from a 100 cm height onto a specific part of each timepiece part, the size of the indent (diameter of the indent) formed in the surface of the timepiece part was measured, and evaluated as follows.
A: no dent observed, or dent diameter < 0.5 mm
B: dent diameter is greater than or equal to 0.5 and less than 1.0 mm (i.e. 0.5 mm <= dent diameter < 1.0)
C: dent diameter is greater than or equal to 1.0 mm and less than 1.5 mm (i.e. 1.0 mm <= dent diameter < 1.5)
D: dent diameter is greater than or equal to 1.5 mm (i.e. dent diameter >= 1.5)

The results are shown in Table 2.

### Table 2

**Table 2**

| | Visual evaluation | Spectrophotometer evaluation | | Corrosion resistance | Scuff-abrasion resistance | Dent resistance |
|---|---|---|---|---|---|---|
| | | a* and b* | L* | | | |
| Example 1 | A | A | A | A | B | B |
| Example 2 | A | A | A | A | B | B |
| Example 3 | A | A | A | A | B | B |
| Example 4 | A | A | A | A | B | B |
| Example 5 | A | A | A | A | A | A |
| Example 6 | A | A | A | A | A | A |
| Example 7 | A | A | A | A | A | A |
| Example 8 | A | A | A | A | A | A |
| Example 9 | A | A | A | A | A | A |
| Example 10 | A | A | A | A | A | A |
| Comparison 1 | A | A | A | A | D | D |
| Comparison 2 | A | A | A | E | D | D |
| Comparison 3 | D | A | D | A | A | A |
| Comparison 4 | A | A | A | A | C | C |
| Comparison 5 | D | A | D | A | A | A |

As will be understood from Table 2, outstanding results were achieved by the invention. An allergic reaction was not observed with the timepiece parts according to the invention when a patch test based on a standard of the International Contact Dermatitis Research Group of the International Society of Dermatology. In an artificial sweat elution test based on JCWA-T003, EN1811, elution of components that may cause an allergic reaction was not observed. Satisfactory results were not obtained with the comparison samples. In addition, stain resistance and feel were particularly outstanding with the timepiece parts of examples 9 and 10 having a coating made of a material including a fluorine-containing organosilicon compound.

Timepiece parts (bands) were also manufactured in the same way as the examples and comparisons described above except for changing the shape of the substrate to a band, and the same results were obtained when the same tests and evaluations were conducted.

Timepiece parts were also manufactured in the same way as examples 5 to 10 described above except for using TiCn instead of TiC for the second coating, and the same results were obtained when the same tests and evaluations were conducted.

A wristwatch as shown in FIG. 6 was also assembled using timepiece parts manufactured according to the above examples and comparisons. When the wristwatch was evaluated in the same way, the same results were also obtained.

The invention being thus described, it will be obvious that it may be varied in many ways. Such variations are not to be regarded as a departure from the spirit and scope of the invention, and all such modifications as would be obvious to one skilled in the art are intended to be included within the scope of the following claims.

The present invention also embraces combinations of the timepiece part structures in the various embodiments. In other words, with ascending order of the numbers of embodiments 1 to 5, the timepiece part of the preceding lower-numbered embodiment may be supplemented by the specifics (i.e. extra layer(s)) of the higher-numbered embodiment(s). Specifically, the timepiece part structure of Embodiment 2 may comprise/consist of all components as defined and described for the timepiece part of Embodiment 1 as basic components plus the extra components and features (underlayer 3) specific to Embodiment 2. Likewise, the timepiece part structure of Embodiment 3 may comprise/consist of all components as defined and described for the timepiece part of Embodiment 2 as basic components plus the extra components and features (second coating 4) specific to Embodiment 3. Likewise, the timepiece part structure of Embodiment 4 may comprise/consist of all components as defined and described for the timepiece part of Embodiment 3 as basic components plus the extra components and features (underlayer 5) specific to Embodiment 4. Finally, likewise, the timepiece part structure of Embodiment 5 may comprise/consist of all components as defined and described for the timepiece structure of Embodiment 4 as basic components plus the extra components and features (coating 6) specific to Embodiment 5.

## Claims

1. A timepiece part comprising:
a substrate; and
a first coating made from a material containing primarily Co and including greater than or equal to 26 wt% and less than or equal to 30 wt% Cr, and greater than or equal to 5 wt% and less than or equal to 7 wt% Mo.

2. The timepiece part described in claim 1, wherein:
the substrate is made from a material including at least one of stainless steel and Ti.

3. The timepiece part described in claim 1 or 2, further comprising:
at least one underlayer made of a material containing Ti between the substrate and first coating.

4. The timepiece part described in any one of claims 1 to 3, further comprising:
a second coating made of a material including at least one of TiC and TiCN between the substrate and first coating.

5. The timepiece part described in claim 3, further comprising:
a second coating made of a material including at least one of TiC and TiCN between the substrate and first coating;
the underlayer being disposed on both sides of the second coating.

6. The timepiece part described in any one of claims 4 to 5, wherein:
the second coating has a region in which the composition changes on a gradient through the thickness.

7. The timepiece part described in any one of claims 4 to 6, wherein:
the second coating has a region in which the total content of C and N decreases toward a surface of the second coating.

8. The timepiece part described in claim 7, wherein:
the second coating has said region on both sides of the second coating.

9. The timepiece part described in any one of claims 4 to 8, wherein:
the thickness of the second coating is greater than or equal to 0.05 µm and less than or equal to 4.0 µm.

10. The timepiece part described in any one of claims 1 to 9, wherein:
the thickness of the first coating is greater than or equal to 0.02 µm and less than or equal to 2.0 µm.

11. The timepiece part described in any one of claims 1 to 10, wherein:
a coating made from a material containing a fluorine-containing organosilicon compound is disposed to the outside surface of the first coating.

12. The timepiece part described in any one of claims 1 to 11, wherein:
the timepiece part is a case member or band.

13. A timepiece comprising a timepiece part according to any one of claims 1 to 12.
